(19) **Europäisches Patentamt / European Patent Office / Office européen des brevets**

(11) **EP 1 652 300 B1**

(12) **EUROPEAN PATENT SPECIFICATION**

(45) Date of publication and mention
of the grant of the patent:
**21.05.2008 Bulletin 2008/21**

(51) Int Cl.:
**H03K 5/08** (2006.01)

(21) Application number: **04743663.9**

(86) International application number:
**PCT/GB2004/003375**

(22) Date of filing: **04.08.2004**

(87) International publication number:
**WO 2005/015740 (17.02.2005 Gazette 2005/07)**

(54) **DIFFERENTIAL CIRCUITS**

DIFFERENZSCHALTUNGEN

CIRCUITS DIFFERENTIELS

(84) Designated Contracting States:
**DE FR GB**

(30) Priority: **04.08.2003 GB 0318238**

(43) Date of publication of application:
**03.05.2006 Bulletin 2006/18**

(73) Proprietor: **Seiko Epson Corporation**
**Shinjuku-ku**
**Tokyo 163-0811 (JP)**

(72) Inventor: **TAM, Simon,**
**Cambridge Research Lab. of Epson**
**Cambridge CB4 0FE (GB)**

(74) Representative: **Cloughley, Peter Andrew et al**
**Miller Sturt Kenyon**
**9 John Street**
**London WC1N 2ES (GB)**

(56) References cited:
**US-A- 4 710 724**

- **PATENT ABSTRACTS OF JAPAN vol. 2000, no. 09, 13 October 2000 (2000-10-13) & JP 2000 165214 A (ASAHI KASEI MICROSYSTEMS KK), 16 June 2000 (2000-06-16)**

**Description**

The present invention relates to differential circuits. Such circuits are used in a wide range of electronic devices including, for example, active matrix display devices.

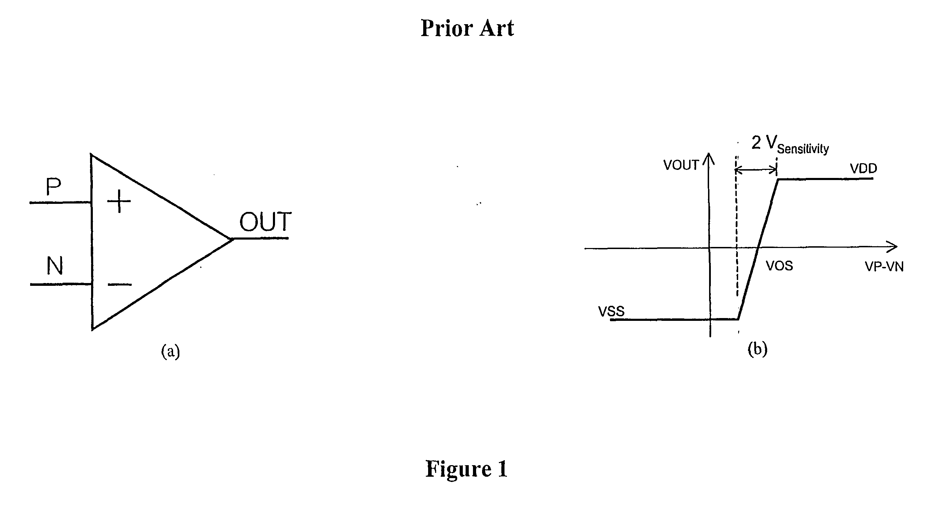

The conventional circuit symbol and graphical definition of a differential voltage comparator are given in Figures 1(a) and 1(b) respectively. The output voltage $V_{OUT}$ is related to the two input voltages at nodes P and N (i.e. $V_P$ and $V_N$) by:

$$\begin{cases} V_{OUT} = V_{DD} & \text{if } (V_P - V_N - V_{OS}) > V_{Sensitivity} \\ V_{OUT} = V_{SS} & \text{if } (V_P - V_N - V_{OS}) < V_{Sensitivity} \end{cases}$$

$$V_{SS} < V_{OUT} < V_{DD} \quad \text{if } |V_P - V_N - V_{OS}| < V_{Sensitivity}$$

where $V_{DD}$ and $V_{SS}$ are the voltages of the supply rails, $V_{os}$ is the input offset-voltage caused by non-ideal transistor characteristics, and $V_{Sensitivity}$ is the minimum difference between input voltages before a full output swing ($V_{DD}$- $V_{SS}$) can occur.

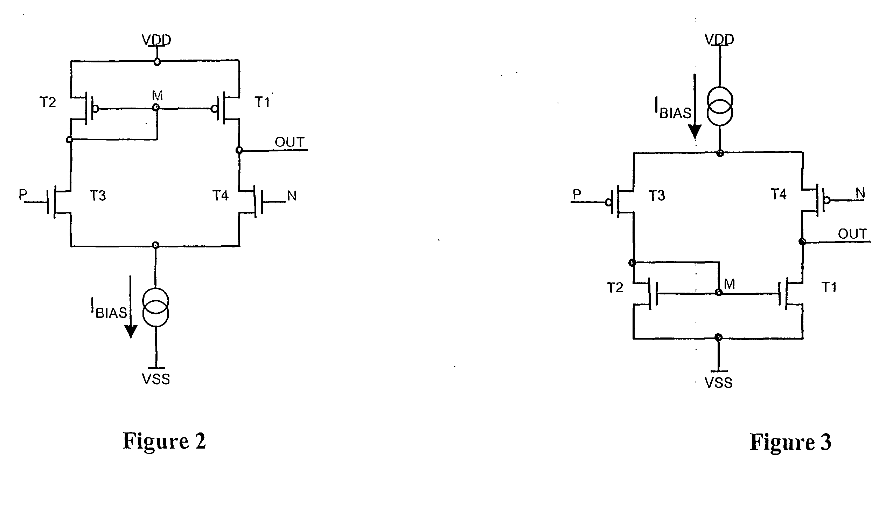

A conventional differential voltage comparator consists of two stages of amplifiers, as is well known in the art. It consists of a differential amplifier circuit as shown in Figures 2 and 3 to perform an amplification of the voltage difference between its two inputs $V_P$ and $V_N$. For optimum operation, a pair of input transistors $T_3$ and $T_4$ identical in characteristics are required to connect to a pair of identical current-mirror transistors $T_1$ and $T_2$. In figure 2 the inputs are NMOS and in figure 3 the inputs are PMOS.

In theory, transistors with the same channel width and length (W and L) dimensions should behave identically. This is normally the case for single crystal technology. However, when the device feature size approaches the sub-micron level, spatial variation of transistor characteristics, although small in absolute terms, becomes a problem. This is because the variation becomes large in relation to the operating voltages. However, when the variation can be described by a linear function of position, this problem can be solved by choosing an appropriate topology for the transistors such that the effect of variation is averaged out. In the case of Thin Film Transistor (TFT) technology, the spatial variation of transistor characteristics is large (in absolute and relative terms) and is randomly distributed. The topological approach cannot be used. An object of the present invention is to solve this problem.

The effect of a random spatial variation of transistor characteristics on a conventional comparator circuit comprising a differential-pair is an unpredictable $V_{OS}$. One proposed solution is to implement additional switches and a capacitor network for detecting and canceling any input offset-voltage $V_{OS}$ caused by the non-ideal transistor characteristics of the comparator circuit. This is effective, but it increases the component count.

Another solution is not to use a differential-pair. A charge-balance differential-voltage comparator requires only the matching of capacitances. Capacitances are easier to match than transistors.

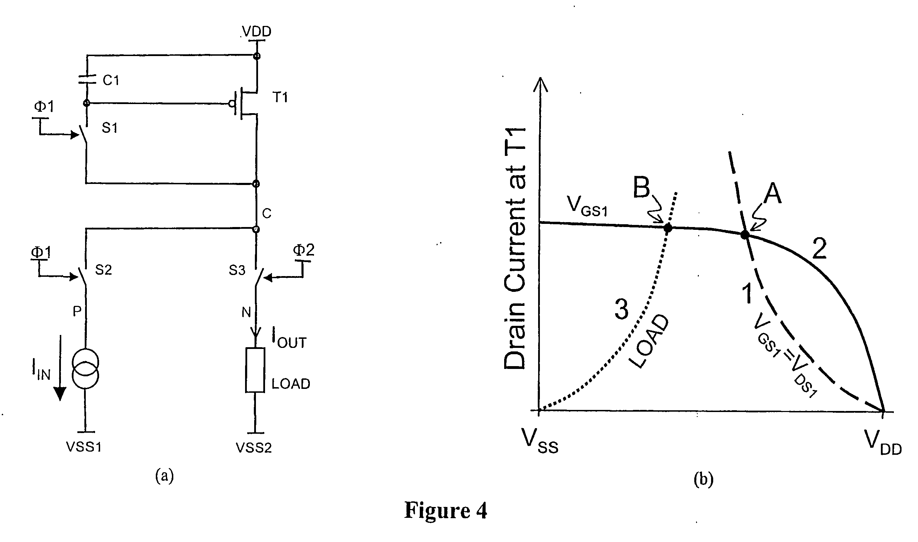

A solution to solve the current-mirror pair problem is to use a single-transistor current-mirror as shown in Figure 4a. This circuit requires two non-overlapping clock pulses $\Phi_1$ and $\Phi_2$ to operate. The input current $I_{IN}$ sets the gate bias voltage $V_{GS1}$ for transistor $T_1$ when the switches $S_1$ and $S_2$ are turned on. This bias condition is stored across $C_1$ and mirrors the $I_{IN}$ as output current $I_{OUT}$ on $T_1$ when $S_3$ is turned on. Figure 4b explains the operation graphically. The current level at point A when $\Phi_1$ is high is similar to the current level at point B when $\Phi_2$ is high (i.e. $I_{OUT} \approx I_{IN}$), thus achieving the current-mirror function. In the illustrated circuit the load is a passive device.

According to the present invention a single transistor current-mirror is interfaced with a suitable load in combination with a suitable set of switches to accomplish a comparator function. The comparator function is, thus, not influenced by the spatial distribution of transistor characteristics.

Embodiments of the present invention will now be described by way of further example only and with reference to the accompanying drawings, in which:-

Figures 1(a) and 1(b) show the conventional circuit symbol and graphical definition of a differential voltage comparator, respectively;

Figure 2 shows the input stage of a conventional comparator circuit using a differential pair with NMOS inputs;

Figure 3 shows the input stage of a conventional comparator circuit using a differential pair with PMOS inputs;

Figures 4(a) and 4(b) respectively show a single transistor current-mirror and a graphical description of the operation of that circuit;

Figures 5(a) and 5(b) respectively a circuit illustrative of the present invention and a graphical representation of the operation of that circuit;

Figure 6 symbolically illustrates the internal mechanism of a differential comparator illustrative of the present invention;

Figure 7 shows the driving waveform of the circuit of figure 6;

Figure 8 illustrates a circuit illustrative of the present invention;

Figure 9 illustrates a circuit according to an embodiment of the present invention;

Figure 10 illustrates a circuit illustrative of the present invention;

Figure 11 illustrates the interface of the circuit illustrative of the embodiment with a following stage in an electronic device;

Figure 12 illustrates another example of the interface of the circuit illustrative of the embodiment with a following stage in an electronic device;

Figure 13(a) illustrates another circuit illustrative of the present invention and figure 13(b) shows the driving waveforms for that circuit;

Figure 14 illustrates a modified form of the circuit of figure 8;

Figure 15 shows simulation results for the circuit of figure 9;

Figure 16 is a symbolic representation of a differential comparator illustrative of the present invention including an output stage;

Figure 17 is a variation of figure 16;

Figure 18 is a detailed diagram of a circuit illustrative of the present invention;

Figure 19 is a circuit diagram illustrating the input stage of an active matrix sensor cell;

Figure 20 is a circuit diagram illustrating a current sensor having a discriminator circuit and an output stage;

Figure 21 is a block diagram useful in explaining the driving method of a multiplexed current sensor for use in a finger print sensor; and

Figure 22 is a timing diagram of a multiplexed current sensor for use in a finger print sensor.

Embodiments of the present invention will now be described in relation to a differential-current comparator circuit. A method of converting this circuit to a differential-voltage comparator will be described subsequently.

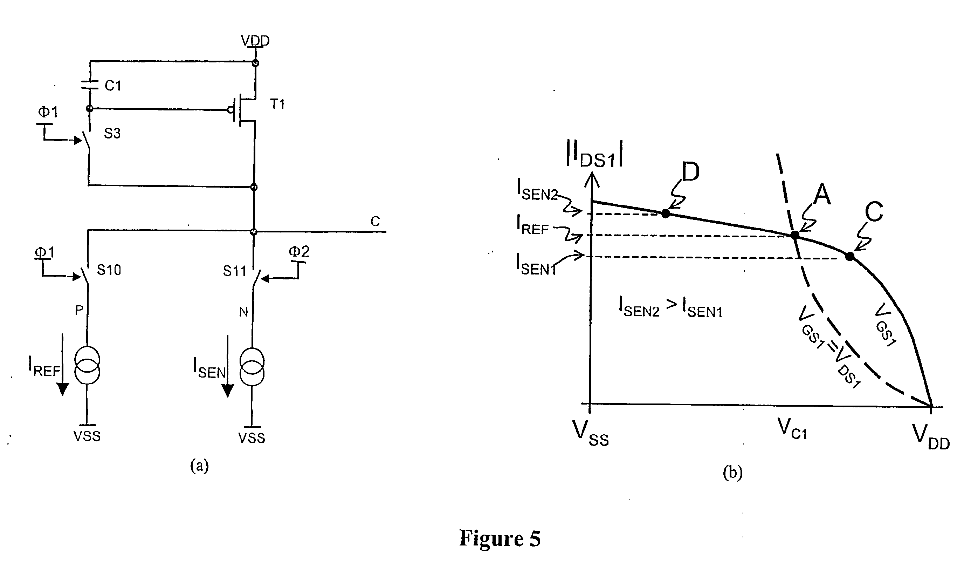

A circuit illustrative of the present invention is illustrated in figure 5a. A single-transistor current mirror comprises a transistor $T_1$ with a capacitor $C_1$ connected between the source and gate thereof and a switch $S_3$ connected between the gate and the drain thereof. The switch S3 is operated by a control signal. The single-transistor current-mirror circuit is connected to two current sources that sink $I_{REF}$ and $I_{SEN}$ through switches $S_{10}$ and $S_{11}$ driven by two non-overlapping clock signals $\Phi_1$ and $\Phi_2$, respectively. The control signal to the single-transistor current-mirror circuit is connected to $\Phi_1$. The output of this circuit is at node C, and the voltage at this node is referred to as $V_C$.

The operation of this circuit is as follows.

Step 1:

$\Phi_1$ goes high while $\Phi_2$ remains low. Switches $S_3$ and $S_{10}$ are now closed. This allows $I_{REF}$ to flow through the diode-connected transistor $T_1$ and causes a voltage (equal to $V_{GS1}$, the gate-source voltage of transistor $T_1$) to appear across the capacitor $C_1$. The value of $C_1$ and the on-resistances of switch $S_3$ dominate the charge-up time. At the end of this cycle, $V_C$ settles at a voltage $V_{C1}$.

Intermediate Step:

Both $\Phi_1$ and $\Phi_2$ are low. All switches are opened. Both current sources are disconnected from the single-transistor current-mirror circuit. The output voltage $V_C$ is floating, or is determined by discharging through the output load (not shown) connected to node C.

Step 2:

$\Phi_2$ goes high while $\Phi_1$ remains low. Switch $S_{11}$ is closed. The circuit is now configured as a source-follower amplifier with a current-source load. The output voltage is determined by the current source $I_{SEN}$. As shown in Figure 5b, at steady-state, if $I_{SEN} = I_{SEN2}$, which is greater than $I_{REF}$, $V_C$ will be less than $V_{C1}$. However, if $I_{SEN} = I_{SEN1}$, Which is less than $I_{REF}$, $V_C$ will be greater than $V_{C1}$.

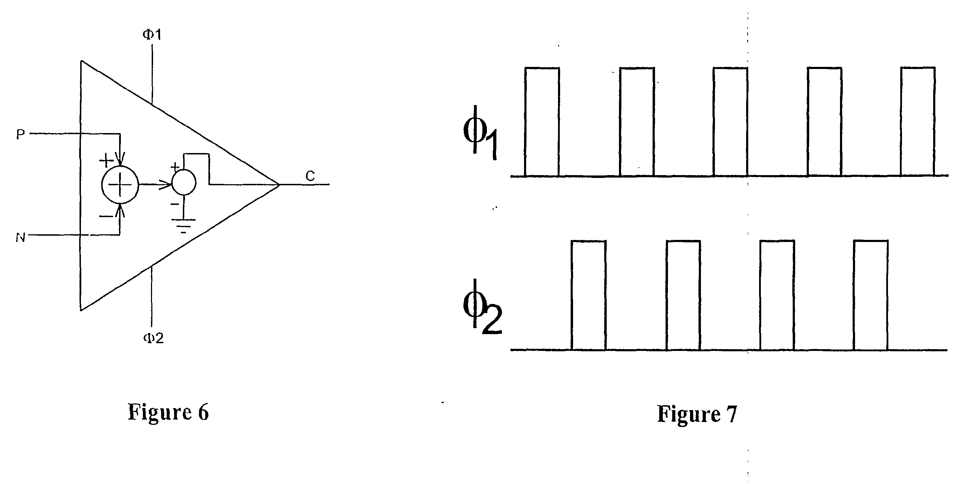

Figure 6 shows a symbol for this differential-current comparator circuit with voltage output. The required driving waveform is given in Figure 7.

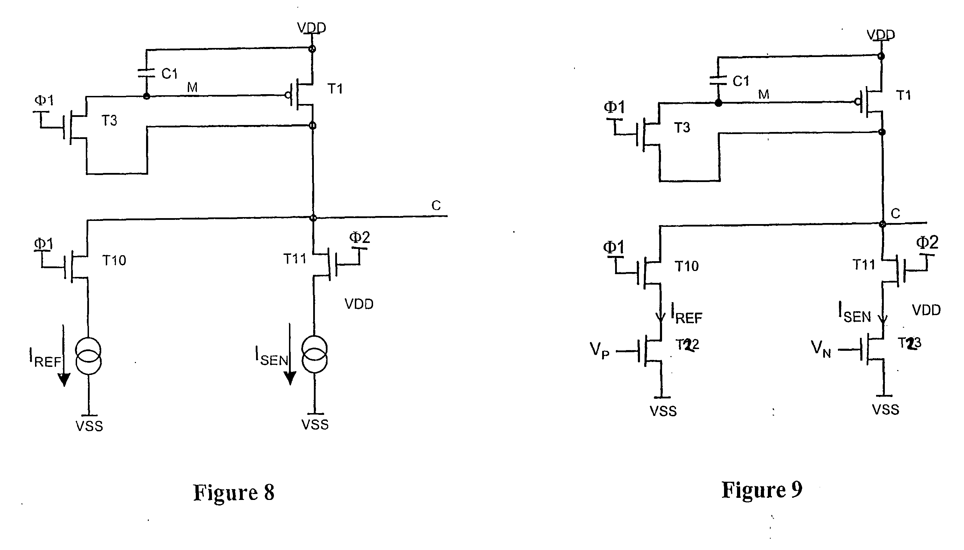

Figure 8 illustrates a specific example embodiment for the basic schematic as shown in Figure 5a. The switches $S_3$, $S_{10}$ and $S_{11}$ in Figure 5a are replaced with n-channel transistors $T_3$, $T_{10}$ and $T_{11}$, respectively. P-channel transistors, in principle, can also be used, but n-channel transistors are preferred because they have a lower on-resistance and hence smaller transistor sizes will be needed. As a result, the voltage feed-through effect of $\Phi_1$ and $\Phi_2$ into nodes C and M is reduced.

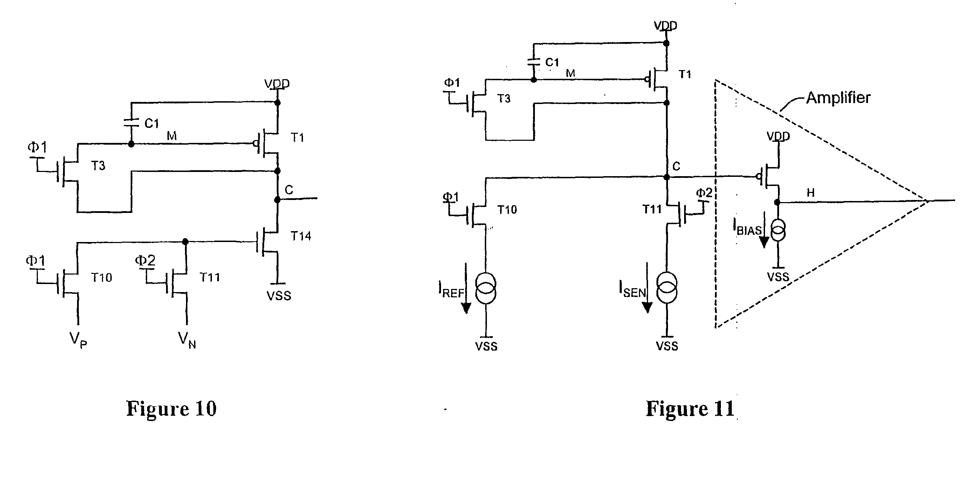

The implementation of the current sources depends on the actual applications. One or both of them can be implemented as independent transistors, such as $T_{22}$ and $T_{23}$ in Embodiment 1 as shown in Figure 9, biased to operate in the saturation region. In Embodiment 1, voltages $V_P$ and $V_N$ controls $T_{22}$ and $T_{23}$ to produce $I_{REF}$ and $I_{SEN}$, respectively. Although the circuit looks like a differential-voltage comparator, care must be taken if it is used as one because the trans-conductance of transistors $T_{12}$ and $T_{13}$ may not have the same characteristic (although they are the same size). The circuit as shown in Figure 10 illustrates how the circuit can be used as a differential-voltage comparator. Transistors $T_{22}$ and $T_{23}$ are merged into a single transistor $T_{14}$, with its gate terminal connected to $V_P$ or $V_N$ via transistor switches $T_{10}$ and $T_{11}$, controlled by $\Phi_1$ and $\Phi_2$, respectively.

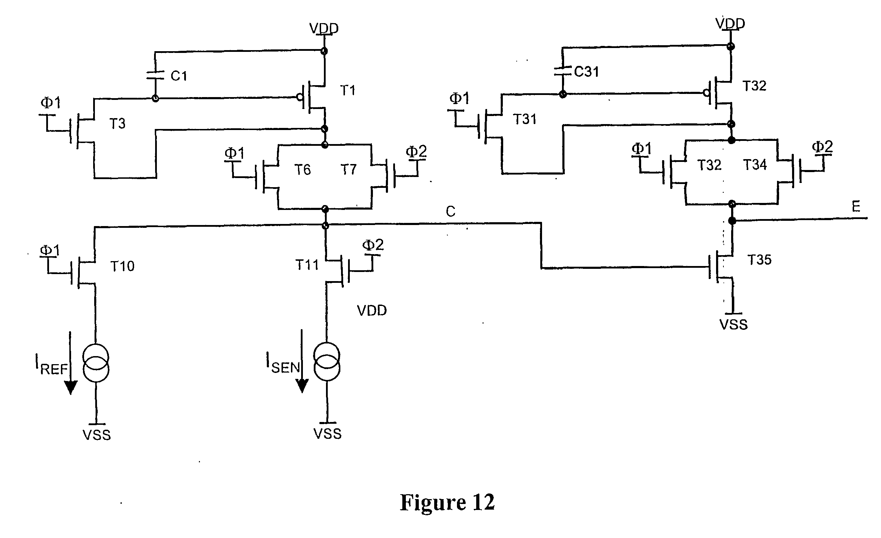

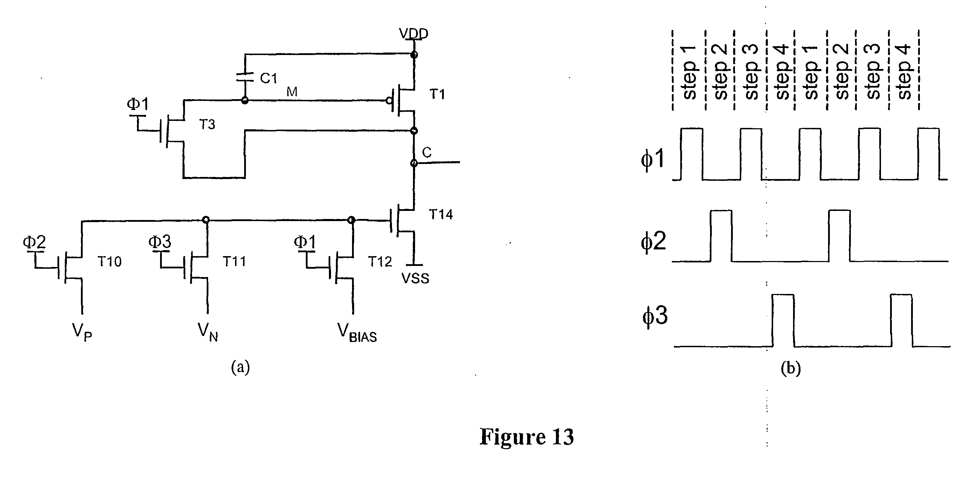

The circuits illustrated in Figures 5a and 8 to 10 pre-amplify the difference between the input signals and pass the difference signal to the next stage. In order to further increase the output voltage swing and to make sure a minimum output load is attached to node C, a traditional MOS input amplifier (such as a single-ended source-follower amplifier) can be used. This is shown in Figure 11. Alternatively, node C may be attached to another single-transistor current-mirror circuit for further amplification, as shown in Figure 12. Essentially, the node C is connected to the gate of a transistor $T_{35}$ which is connected between VSS and the output of the second single transistor current mirror. In addition, with reference to figure 10 and as shown in Figure 13a, the basic circuit can be expanded by introducing additional transistor switches. In figure 13a, transistor $T_{12}$ is connected between $V_{BIAS}$ and the gate of transistor $T_{14}$. Additional non-overlapping clock pulses such as that shown in Figure 13b will also be required. In figure 13a; $\Phi_1$ is applied to the gate of $T_{12}$, $\Phi_2$ is applied to the gate of $T_{10}$ and $\Phi_3$ is applied to the gate of $T_{11}$.

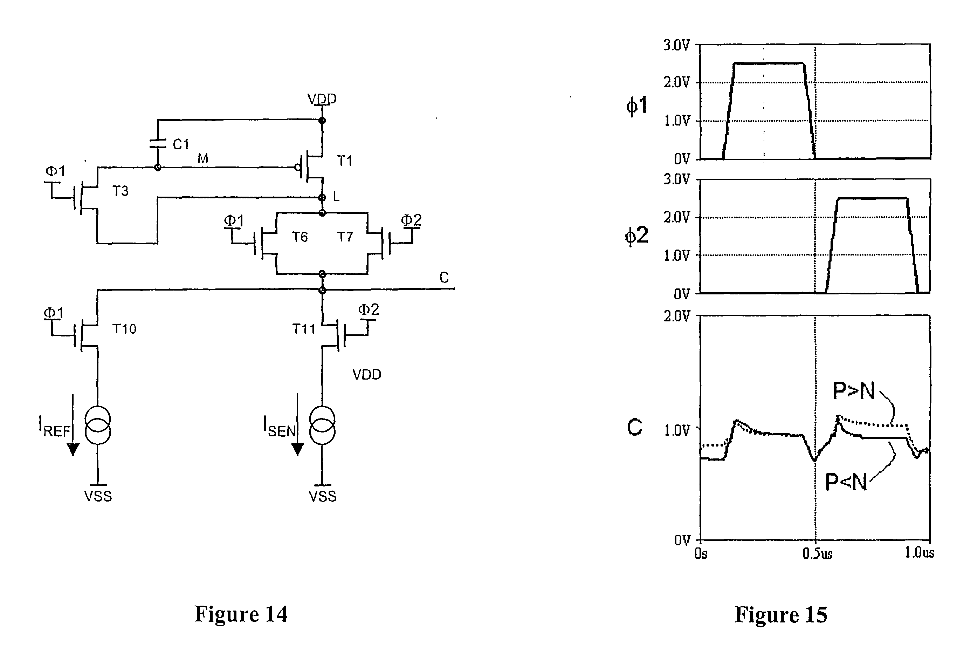

The circuits described above in relation to figures 5 to 13 can be modified to improve performance. When $\Phi1$ goes down, the nodal voltage at nodes C and M are pulled down by the voltage feed-through effect at $T_3$ and $T_{10}$. Node C suffers the voltage feed-through effect from both $T_3$ and $T_{10}$ and hence a greater disturbance results. This disturbance could lead to an unexpected output spike at the second comparator stage. To avoid this problem, additional transistors $T_6$ and $T_7$ may be introduced to isolate node C from transistor $T_1$. The circuit of figure 8 modified in this way is illustrated in figure 14. Additional transistors $T_6$ and $T_7$ are connected in parallel with each other and have their gates each effectively connected with a respective one of the two current source switches ($T_{10}$ and $T_{11}$), so as to receive the respective drive signal ($\Phi_1$ and $\Phi_2$) applied to the current source switches.

Simulation results for the circuit as shown in Figure 9 with this modification added are shown in Figure 15, with the circuit using polysilicon TFTs. $V_C$ falls during the falling edge of $\Phi_1$, but rises by the same amount during the rising edge of $\Phi_2$, therefore the initial operating point of $V_C$ during $\Phi_2$ is unaffected.

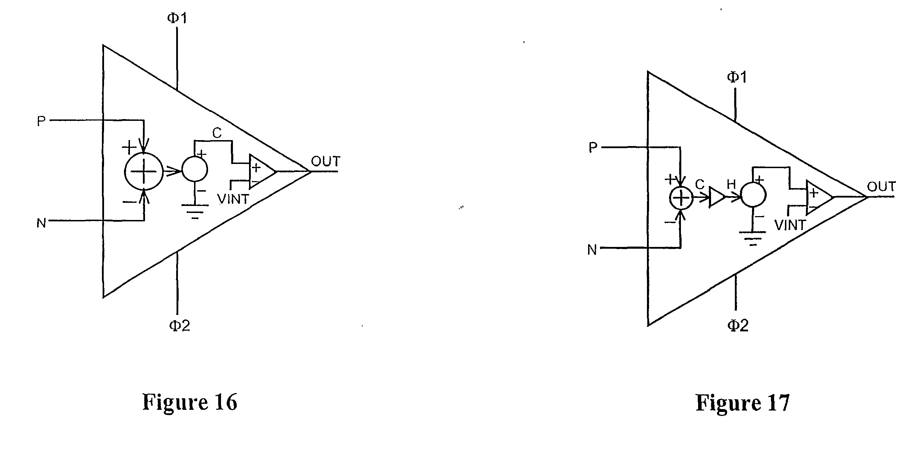

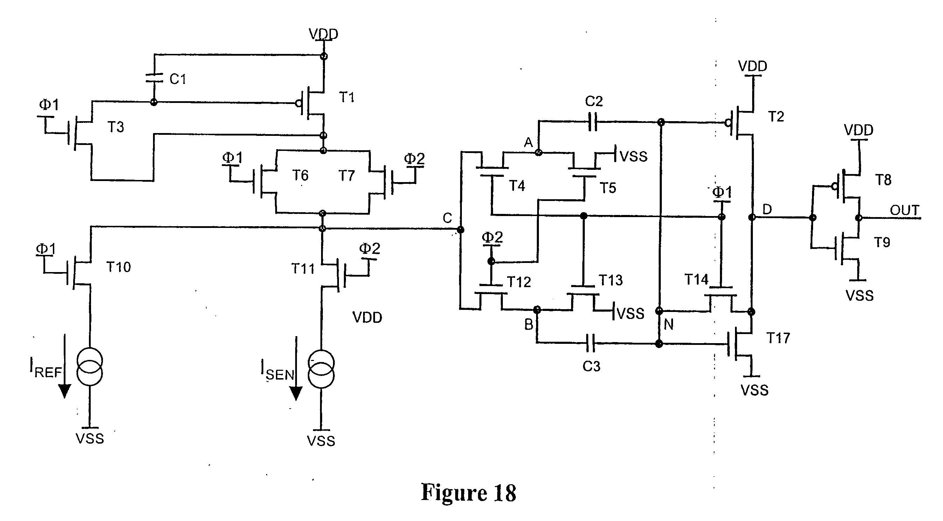

Figures 16 and 17 illustrate schematically how the input stage can be interfaced to a subsequent stage. Figure 18 is a detailed circuit diagram of the input and self-bias comparator, illustrative of the present invention. The first stage of the circuit is exactly the circuit of figure 14. The output node C is connected to the input of a self bias comparator, the body of which comprises transistors $T_2$, $T_4$, $T_5$, $T_{12}$, $T_{13}$, $T_{14}$ and $T_{17}$ together with capacitors $C_2$ and $C_3$. The output

stage of the self bias comparator comprises transistors $T_8$ and $T_9$. Node C is connected to the source of both of transistors $T_4$ and $T_{12}$. The drains thereof are respectively coupled through capacitors C2 and C3 to the respective gates of $T_2$ and $T_{17}$. The drains of $T_4$ and $T_{12}$ are also respectively connected to the source of $T_5$ and $T_{13}$. The drain of both $T_5$ and $T_{13}$ are both connected to VSS. Control signal $\Phi_1$ is applied to the gates of $T_4$ and $T_{13}$. Control signal $\Phi_2$ is applied to the gates of $T_5$ and $T_{12}$. The gates of $T_2$ and $T_{17}$ are connected to each other and to the source of a transistor $T_{14}$, whose drain is connected to the source of $T_{17}$ and whose gate receives signal $\Phi_1$. The source of $T_2$ is connected to VDD and it's drain is connected to the source of $T_{17}$. The drain of $T_{17}$ is connected to VSS. The interconnection of the drain of $T_2$ and the source of $T_{17}$ provides the output to the gates of both $T_8$ and $T_9$. The source of $T_8$ is connected to VDD. The drain of $T_9$ is connected to VSS and the interconnection between the drain of $T_8$ and the source of $T_9$ provides the final circuit output.

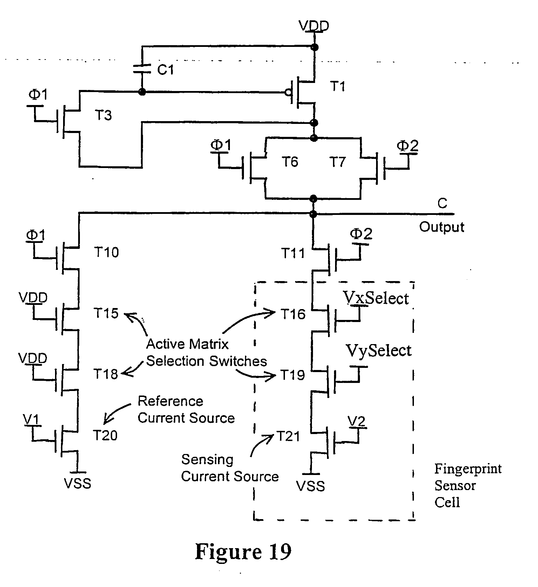

This invention can be used in detecting the peak and valley in a fingerprint sensor. An example of a fingerprint sensor circuit is shown in Figure 19. The current source for $I_{SEN}$ is the output signal from a sensor pixel of an active matrix sensor array. Thus, comparing figure 19 with figure 14 it will be seen that the reference current source is provided by transistor $T_{20}$, whose gate receives a voltage $V_1$, and that the sensing current source is provided by transistor $T_{21}$, whose gate receives a voltage $V_2$. Respectively between $T_{20}$ and $T_{10}$ and between $T_{21}$ and $T_{11}$ are active matrix selection switches $T_{15}$ and $T_{18}$, and, $T_{16}$ and $T_{19}$. When the sensing cell is selected the voltage VDD is applied to the gates of all of transistors $T_{15}$, $T_{18}$, $T_{16}$ and $T_{19}$.

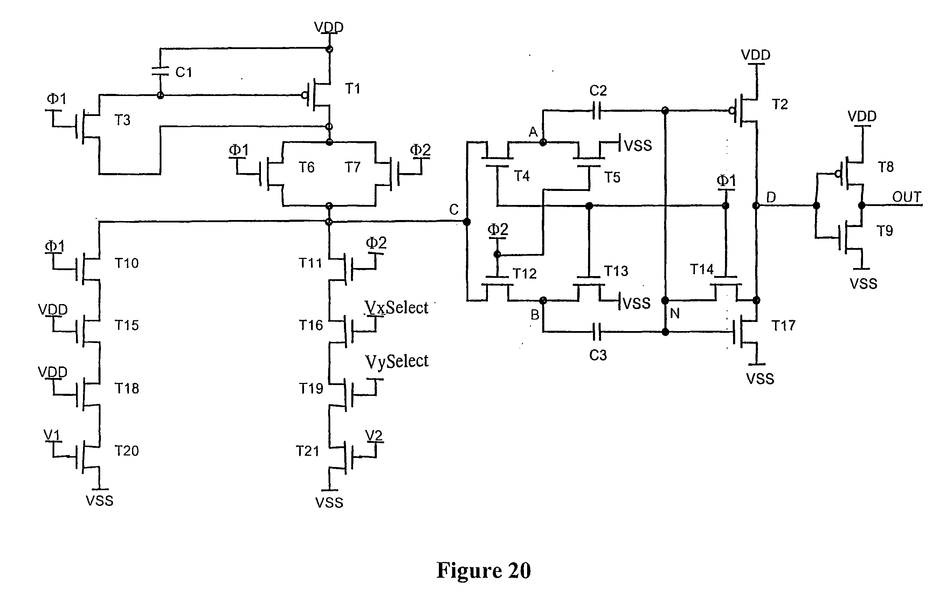

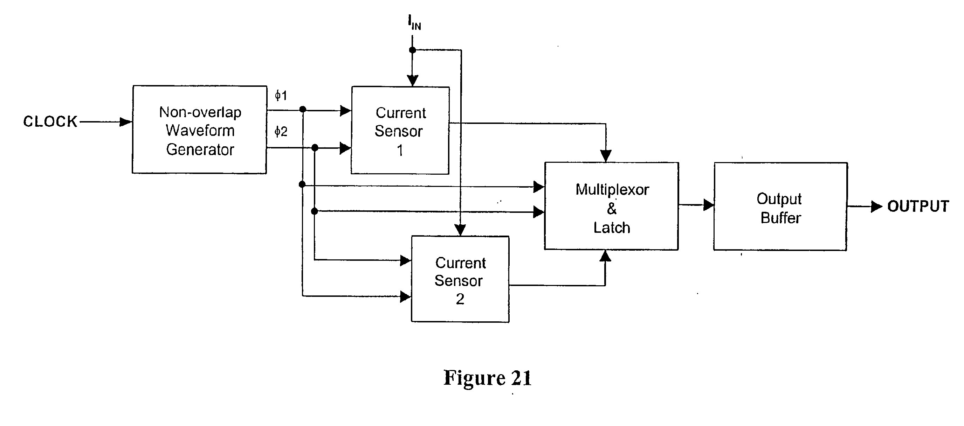

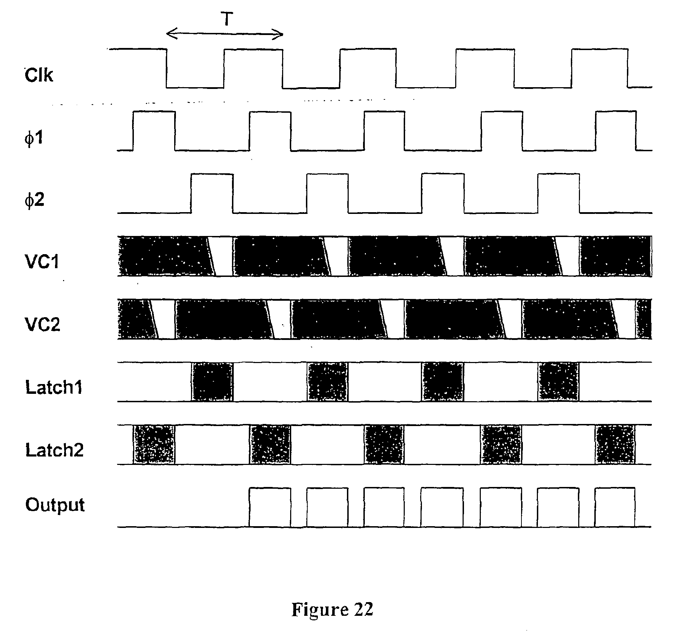

Figure 20 shows an embodiment of a current sensor circuit having a self-bias charge-balance comparator as the output stage. The input stage is the circuit of figure 19 and the same self bias comparator as shown in figure 18 forms the output stage. The driving scheme is shown in Figure 21. A non-overlap waveform generator outputs $\Phi_1$ and $\Phi_2$ which are applied as inputs to a first and second current sensor as well as to a multiplexor and latch circuit. The two current sensors receive an input current $I_{in}$ and have their respective outputs connected to the multiplexor and latch circuit. The output of the multiplexor and latch circuit is fed through an output buffer stage so as to provide the final circuit output. The timing diagram for the circuit explained in figures 20 and 21 is shown in Figure 22.

The aforegoing description has been given by way of example only and it will be appreciated by a person skilled in the art that modifications can be made without departing from the scope of the present invention as defined in the claims. For example, in figure 20 if the P type transistors are replaced by N type transistors and visa versa then $V_{DD}$ becomes Vss and Vss becomes $V_{DD}$.

**Claims**

**1.** A differential circuit comprising:

a first transistor (T1) that has a first drain and a first source;
a capacitor (C1) that is connected to a first gate of the first transistor;
a first switch (T3) that controls an electrical connection between the first gate and the first drain;
a second transistor (T22) that has a second drain and a second source;
a third transistor (T23) that has a third drain and a third source;
a second switch (T10) that controls an electrical connection between the first transistor and the second transistor; and
a third switch (T11) that controls an electrical connection between the first transistor and the third transistor, the differential circuit being configured such that a first period in which the first transistor is electrically connected to the second transistor through the second switch does not overlap a second period in which the first transistor is electrically connected to the third transistor through the third switch.

**2.** The differential circuit according to claim 1, wherein the differential circuit is configured such that a first current flows through the first transistor and the second transistor during the first period.

**3.** The differential circuit according to claims 1 or 2, wherein the differential circuit is configured such that a second current flows through the first transistor and the third transistor during the second period.

**4.** The differential circuit according to any one of claims 1-3, wherein the differential circuit is configured such that each of the second transistor and the third transistor functions as a current source.

**5.** The differential circuit according to any one of claims 1-4,
wherein the differential circuit is configured such that the first gate is electrically connected to the first drain through the first switch during the first period.

**6.** The differential circuit according to any one of claims 1-5,
wherein the differential circuit is configured such that the first switch and the second switch are controlled by an identical signal.

**7.** The differential circuit according to any one of claims 1-6,
further comprising an amplifier that is connected to the first transistor.

**8.** The differential circuit according to any one of claims 1-7,
wherein the differential circuit is configured such that any one of the second drain and the second source and any one of the third drain and the third source are electrically connected to a predetermined potential (Vss);

**9.** The differential circuit according to claim 2,
wherein the differential circuit is configured such that a charge corresponding to the first current is charged to the capacitor during the first period.

**10.** The differential circuit according to claim 9,
wherein the differential circuit is configured such that the first gate is electrically connected to the first drain through the first switch.

**11.** The differential circuit according to any one of claims 1-10,
wherein the differential circuit is configured such that the differential circuit amplifies an output of a sensor pixel.

**12.** An electronic device comprising the differential circuit according to any one of claims 1-11.


**Patentansprüche**

**1.** Differenzschaltung, umfassend:

einen ersten Transistor (T1), der einen ersten Drain und eine erste Source hat;
einen Kondensator (Cl), der an ein erstes Gate des ersten Transistors angeschlossen ist;
einen ersten Schalter (T3), der eine elektrische Verbindung zwischen dem ersten Gate und dem ersten Drain steuert;
einen zweiten Transistor (T22), der einen zweiten Drain und eine zweite Source hat;
einen dritten Transistor (T23), der einen dritten Drain und eine dritte Source hat;
einen zweiten Schalter (T10), der eine elektrische Verbindung zwischen dem ersten Transistor und dem zweiten Transistor steuert; und
einen dritten Schalter (T11), der eine elektrische Verbindung zwischen dem ersten Transistor und dem dritten Transistor steuert,
wobei die Differenzschaltung so konfiguriert ist, dass eine erste Periode, in der der erste Transistor durch den zweiten Schalter elektrisch an den zweiten Transistor angeschlossen ist, eine zweite Periode nicht überlappt, in der der erste Transistor durch den dritten Schalter an den dritten Transistor angeschlossen ist.

**2.** Differenzschaltung nach Anspruch 1,
wobei die Differenzschaltung so konfiguriert ist, dass in der ersten Periode ein erster Strom durch den ersten Transistor und den zweiten Transistor strömt.

**3.** Differenzschaltung nach Anspruch 1 oder 2,
wobei die Differenzschaltung so konfiguriert ist, dass in der zweiten Periode ein zweiter Strom durch den ersten Transistor und den dritten Transistor strömt.

**4.** Differenzschaltung nach einem der Ansprüche 1 bis 3,
wobei die Differenzschaltung so konfiguriert ist, dass jeder von dem zweiten Transistor und dem dritten Transistor als Stromquelle dient.

**5.** Differenzschaltung nach einem der Ansprüche 1 bis 4,
wobei die Differenzschaltung so konfiguriert ist, dass in der ersten Periode das erste Gate durch den ersten Schalter elektrisch an den ersten Drain angeschlossen ist.

**6.** Differenzschaltung nach einem der Ansprüche 1 bis 5,
wobei die Differenzschaltung so konfiguriert ist, dass der erste Schalter und der zweite Schalter durch ein identisches Signal gesteuert werden.

**7.** Differenzschaltung nach einem der Ansprüche 1 bis 6,
des Weiteren umfassend einen Verstärker, der an den ersten Transistor angeschlossen ist.

**8.** Differenzschaltung nach einem der Ansprüche 1 bis 7,
wobei die Differenzschaltung so konfiguriert ist, dass eines von dem zweiten Drain und der zweiten Source und eines von dem dritten Drain und der dritten Source elektrisch an ein vorbestimmtes Potenzial (Vss) angeschlossen sind.

**9.** Differenzschaltung nach Anspruch 2,
wobei die Differenzschaltung so konfiguriert ist, dass eine Ladung, die dem ersten Strom entspricht, in der ersten Periode in den Kondensator geladen wird.

**10.** Differenzschaltung nach Anspruch 9,
wobei die Differenzschaltung so konfiguriert ist, dass das erste Gate durch den ersten Schalter elektrisch an den ersten Drain angeschlossen ist.

**11.** Differenzschaltung nach einem der Ansprüche 1 bis 10,
wobei die Differenzschaltung so konfiguriert ist, dass die Differenzschaltung einen Ausgang eines Sensorpixels verstärkt.

**12.** Elektronisches Gerät, umfassend die Differenzschaltung nach einem der Ansprüche 1 bis 11.

## Revendications

**1.** Circuit différentiel comprenant :

un premier transistor (T1) possédant un premier drain et une première source;
un condensateur (C1) connecté à une première grille du premier transistor ;
un premier commutateur (T3) qui contrôle une connexion électrique entre la première grille et le premier drain;
un deuxième transistor (T22) qui possède un deuxième drain et une deuxième source;
un troisième transistor (T23) qui possède un troisième drain et une troisième source ;
un deuxième commutateur (T10) qui contrôle une connexion électrique entre le premier transistor et le deuxième transistor; et
un troisième commutateur (T11) qui contrôle une connexion électrique entre le premier transistor et le troisième transistor,
le circuit différentiel étant configuré de manière à ce qu'une première période au cours de laquelle le premier transistor est connecté électriquement au deuxième transistor par l'intermédiaire du deuxième commutateur ne se superpose pas à une seconde période au cours de laquelle le premier transistor est connecté électriquement au troisième transistor par l'intermédiaire du troisième commutateur.

**2.** Circuit différentiel selon la revendication 1,
le circuit différentiel étant configuré de manière à ce qu'un premier courant circule à travers le premier transistor et le deuxième transistor au cours de la première période.

**3.** Circuit différentiel selon les revendications 1 ou 2,
le circuit différentiel étant configuré de manière à ce qu'un deuxième courant circule à travers le premier transistor et le troisième transistor au cours de la seconde période.

**4.** Circuit différentiel selon l'une quelconque des revendications 1-3,

le circuit différentiel étant configuré de manière à ce que chacun des deuxième transistor et troisième transistor fonctionne en tant que source de courant.

5. Circuit différentiel selon l'une quelconque des revendications 1-4,
le circuit différentiel étant configuré de manière à ce que la première grille soit connectée électriquement au premier drain par l'intermédiaire du premier commutateur au cours de la première période.

6. Circuit différentiel selon l'une quelconque des revendications 1-5,
le circuit différentiel étant configuré de manière à ce que le premier commutateur et le deuxième commutateur soient contrôlés grâce à un signal identique.

7. Circuit différentiel selon l'une quelconque des revendications 1-6,
comprenant par ailleurs un amplificateur qui est connecté au premier transistor.

8. Circuit différentiel selon l'une quelconque des revendications 1-7,
le circuit différentiel étant configuré de manière à ce que l'un ou l'autre parmi le deuxième drain et la deuxième source et l'un ou l'autre parmi le troisième drain et la troisième source soient connectés électriquement à un potentiel prédéterminé (Vss).

9. Circuit différentiel selon la revendication 2,
le circuit différentiel étant configuré de manière à ce qu'une charge correspondant au premier courant soit chargée dans le condensateur au cours de la première période.

10. Circuit différentiel selon la revendication 9,
le circuit différentiel étant configuré de manière à ce que la première grille soit connectée électriquement au premier drain par l'intermédiaire du premier commutateur.

11. Circuit différentiel selon l'une quelconque des revendications 1-10,
le circuit différentiel étant configuré de manière à ce que le circuit différentiel amplifie une sortie d'un pixel de capteur.

12. Dispositif électronique comprenant le circuit différentiel selon l'une quelconque des revendications 1-11.

(a)

(b)

Figure 1

Figure 3

Figure 2

Figure 4

(a)

(b)

Figure 5

EP 1 652 300 B1

**Figure 7**

**Figure 6**

Figure 8

Figure 9

EP 1 652 300 B1

**Figure 11**

**Figure 10**

**Figure 12**

EP 1 652 300 B1

**Figure 13**

Figure 14

Figure 15

EP 1 652 300 B1

Figure 17

Figure 16

19

**Figure 18**

**Figure 19**

Figure 20

**Figure 21**

Figure 22